# FASCICULE DE BREVET EUROPEEN

(11) **EP 0 679 899 B1**
(45) Date de publication et mention de la délivrance du brevet: **10.07.2002**
(21) Numéro de dépôt: 95106145.6
(22) Date de dépôt: 25.04.1995
(51) Int. Cl.: G01R 31/316, G01R 31/26, H01L 21/66

(54) **Capteur comprenant une pluralité de capteurs locaux, notamment des photodiodes**
Detektor, bestehend aus einer Vielzahl von lokalen Detektoren, insbesondere von Fotodioden
Detector comprising a plurality of local detectors, in particular photodiodes

(30) Priorité: 29.04.1994 FR 9405257
(43) Date de publication de la demande: 02.11.1995
(73) Titulaire: CSEM Centre Suisse d'Electronique et de Microtechnique S.A., 2007 Neuchâtel (CH)
(72) Inventeur: Chevroulet, Michel Alain, CH-2000 Neuchâtel (CH)
(74) Mandataire: Ravenel, Thierry Gérard Louis

(56) Documents cités:
- EP-A- 0 288 804
- WO-A-90/06521
- US-A- 4 749 947
- US-A- 5 168 379
- US-A- 5 276 400
- IEEE TRANSACTIONS ON INSTRUMENTATION AND MEASUREMENT, vol. 41, no. 4, Août 1992 NEW YORK US, pages 535-539, C.-L WEY ET AL 'Built-in self-test (BIST) structures for analog circuit fault diagnosis with current test data'
- IBM TECHNICAL DISCLOSURE BULLETIN, vol. 18, no. 7, Décembre 1975 NEW YORK US, pages 2181-2182, D.K. JADUS ET AL 'Test pad multiplexing'

## Description

La présente invention concerne un capteur comprenant une pluralité de capteurs locaux, notamment des photodiodes.

Le document US-A-5 168 379 décrit un capteur avec N cellules élémentaires comprenant chacune un capteur local et un circuit local fournissant un signal élémentaire en réponse au signal du capteur. Un des signaux élémentaires peut être sélectionné par un circuit d'adressage pour être transmis à une sortie du circuit.

En particulier, la présente invention concerne un capteur agencé de manière à fournir un signal global représentatif d'une fonction globale sur l'ensemble des capteurs locaux de ce capteur. Cette fonction globale est par exemple une fonction de maximum ou de minimum d'intensité lumineuse reçue par le capteur. Une application possible pour un tel capteur est la détection du maximum d'intensité lumineuse reçue par l'objectif d'une caméra ou d'un appareil photographique.

Dans le cas du dernier capteur susmentionné, les capteurs locaux n'ont aucune connexion directe et individuelle à un circuit de mesure permettant de connaître individuellement l'état de fonctionnement de chaque capteur local.

Ainsi, il n'est pas possible de tester individuellement chaque capteur local à l'aide du seul circuit électronique nécessaire pour engendrer ledit signal global lorsqu'il n'est pas concevable d'activer individuellement chaque capteur local, ce qui est généralement le cas dans un test industriel pour de tels capteurs.

Pour pouvoir effectuer un test industriel de l'état de fonctionnement de chaque capteur local, notamment de chaque photodiode, il est généralement connu d'agencer dans le capteur une liaison électrique directe et individuelle entre chaque capteur local et un circuit de test.

L'agencement de test susmentionné présente deux inconvénients majeurs. Premièrement, cet agencement de test ne permet pas de tester le fonctionnement du circuit de mesure du capteur. Deuxièmement, cet agencement de test nécessite autant de liaisons électriques directes et individuelles qu'il y a de capteurs locaux. Dans le cas d'un capteur bidimensionnel ayant ses capteurs locaux disposés sous forme de matrice, c'est-à-dire d'un tableau à Y lignes et Z colonnes, de telles liaisons électriques directes et individuelles posent un problème technique de réalisation, ce qui engendre une augmentation du coût de fabrication et engendre également une augmentation de l'encombrement du capteur.

Un premier but de l'invention est de pallier le premier inconvénient susmentionné en fournissant un capteur muni d'un système de test permettant de tester individuellement chaque capteur local et le circuit de mesure de ce capteur.

Un deuxième but de l'invention est de fournir un tel capteur tout en palliant le deuxième inconvénient susmentionné.

Un troisième but de l'invention est de fournir un tel capteur muni d'un système de test permettant également de tester l'électronique de mesure sans activer les capteurs locaux.

Le premier but de l'invention susmentionné est réalisé par un dispositif selon l'invention comprenant N cellules élémentaires comprenant chacune un ensemble local formé d'un capteur local, susceptible de fournir un signal de mesure à une sortie de ce capteur local, et d'un circuit local agencé de manière à fournir un signal élémentaire en réponse audit signal de mesure. Ce dispositif selon l'invention comprend en outre un circuit global agencé de manière à fournir un signal global qui est fonction des N signaux élémentaires fournis simultanément par les N circuits locaux. Chacune des N cellules élémentaires comprend en outre des moyens d'inhibition, répondant à un premier signal de commande susceptible de prendre sélectivement une première valeur et une deuxième valeur, pour agir sur l'ensemble local de cette cellule élémentaire de manière que le signal élémentaire fourni par le circuit local de cette cellule élémentaire soit sensiblement sans influence sur le signal global lorsque le premier signal de commande a ladite première valeur. D'autre part, les moyens d'inhibition n'ont pas d'influence significative sur l'ensemble local de la cellule élémentaire lorsque le premier signal de commande a ladite deuxième valeur.

Selon d'autres caractéristiques de l'invention, le circuit local a une entrée reliée électriquement à la sortie du capteur local et les moyens d'inhibition sont reliés électriquement à la sortie du capteur local. Ces moyens d'inhibition sont agencés pour fournir un signal d'inhibition à ladite sortie du capteur local lorsque le premier signal de commande a ladite première valeur.

Il résulte des caractéristiques susmentionnées qu'il est possible d'inhiber, par une commande appropriée de chacun des moyens d'inhibition des N cellules élémentaires, le signal de mesure fourni par tous les capteurs locaux, à l'exclusion d'un quelconque de ces capteurs locaux. Dans ce cas, seule la contribution de ce dernier capteur local intervient dans le signal global fourni par le circuit global.

Ainsi, il est possible de tester chaque capteur local et le circuit local qui lui est associé à travers le circuit global réalisant la fonction globale. De ce fait, l'ensemble de l'électronique de mesure est testée par l'agencement de test selon l'invention.

Selon d'autres caractéristiques particulières de l'invention, le signal de mesure fourni par chaque capteur local est un courant électrique et les moyens d'inhibition de chaque cellule élémentaire comprennent un premier transistor et un deuxième transistor ayant leurs bornes de sortie reliées à ladite sortie du capteur local et leurs bornes de commande susceptibles d'être reliées à un circuit de commande. Ce dernier est agencé de manière à leur fournir le premier signal de commande sous la forme de deux signaux binaires agissant respectivement sur les deux bornes de commande des premier et deuxième transistors.

Le deuxième but de l'invention est réalisé par un mode de réalisation préféré de l'invention comportant les caractéristiques particulières mentionnées ci-avant et dans lesquelles les cellules élémentaires sont disposées sous une forme matricielle. De plus, le premier transistor d'une quelconque des N cellules élémentaires a sa borne de commande reliée en parallèle avec les bornes de commande des premiers transistors, appartenant aux cellules élémentaires situées sur la même ligne de la matrice, à une même première borne de test. De même, le deuxième transistor d'une quelconque des N cellules élémentaires a sa borne de commande reliée en parallèle avec les bornes de commande des deuxièmes transistors, appartenant aux cellules élémentaires situées sur la même colonne de la matrice, à une même deuxième borne de test.

De ce fait, le nombre de bornes de test nécessaire au circuit de test pour fournir le premier signal de commande à chaque cellule élémentaire, tout en réalisant le premier but de l'invention, est moindre que dans le cas d'un adressage direct et individuel de chaque cellule élémentaire dès que la matrice comprend plus de deux lignes ou plus de deux colonnes. Pour une matrice carrée ayant N lignes et N colonnes, le nombre de bornes de test est égal à deux fois N dans le mode de réalisation préféré de l'invention, alors qu'il est égal à N² dans l'agencement de test de l'art antérieur mentionné ci-avant.

Le troisième but de l'invention est réalisé par d'autres caractéristiques complémentaires, à savoir que chacune des N cellules élémentaires comprend en outre des moyens de stimulation reliés électriquement à la sortie du capteur local et susceptibles de fournir à cette sortie un signal de stimulation lorsque ces moyens de stimulation sont activés.

En particulier, les moyens de stimulation comprennent un troisième transistor dont la borne de commande est susceptible d'être reliée à un circuit externe servant à contrôler la valeur de la tension à la borne de commande de ce troisième transistor.

Ainsi, par exemple dans le cas où les capteurs locaux sont des photodiodes, il est possible de tester chaque circuit local et le circuit global sans exposer le capteur à une lumière d'activation.

D'autres caractéristiques et avantages de l'invention seront décrits ci-après à l'aide de la description suivante faite en référence aux dessins annexés, donnés à titre d'exemples nullement limitatifs, dans lesquels :
- la figure 1 représente schématiquement un premier mode de réalisation de l'invention;
- la figure 2 représente schématiquement les caractéristiques courant-tension des éléments reliés électriquement au point X de la figure 1;
- la figure 3 représente schématiquement un deuxième mode de réalisation de l'invention;
- la figure 4 représente schématiquement un troisième mode de réalisation de l'invention;
- la figure 5 est une variante de réalisation du troisième mode de réalisation de l'invention.

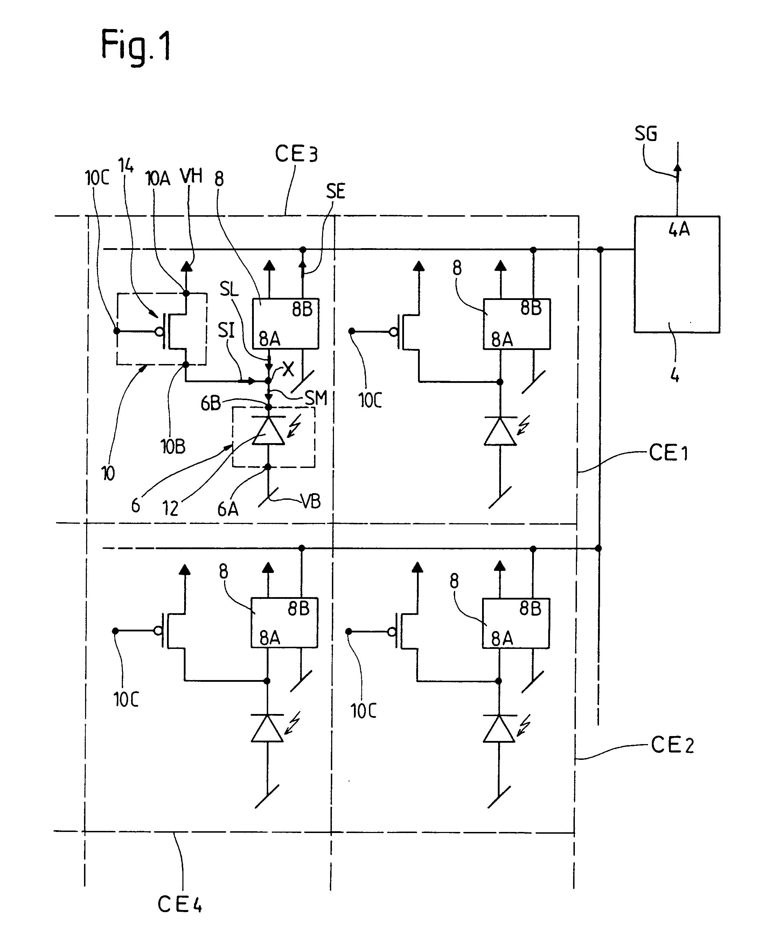

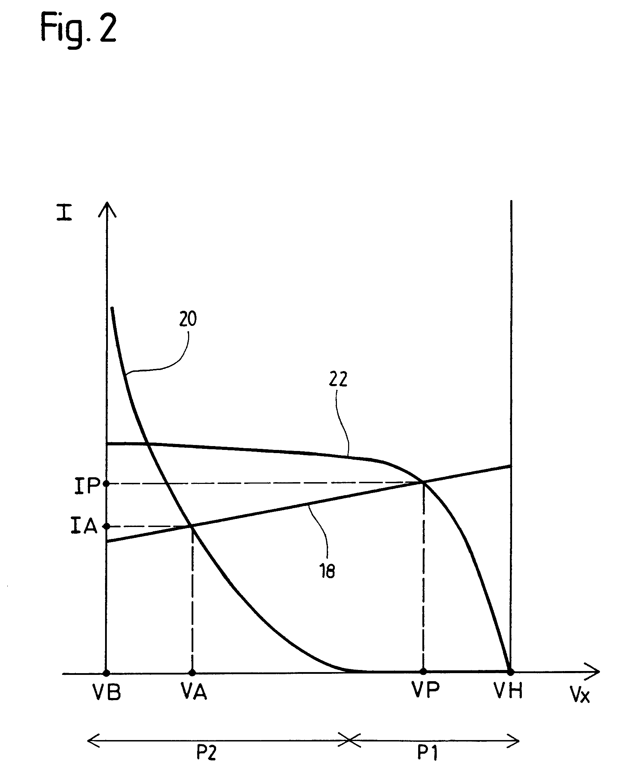

En se référant aux figures 1 et 2, on décrira ci-après un premier mode de réalisation de l'invention.

Le dispositif selon ce premier mode de réalisation comprend une pluralité de cellules élémentaires dont seulement quatre cellules élémentaires CE1, CE2, CE3 et CE4 ont été représentées sur la figure 1. Ce dispositif comprend en outre un circuit électronique global 4 relié électriquement à chacune desdites cellules élémentaires.

Chaque cellule élémentaire du dispositif décrit sur la figure 1 est identique aux autres. Ainsi, sur la figure 1, seule une cellule élémentaire comporte les références de l'ensemble des éléments compris dans chacune des cellules élémentaires.

Chaque cellule élémentaire comprend un capteur local 6 ayant une entrée 6A reliée à un pôle négatif VB d'une source d'alimentation (non représentée), un circuit local 8 et un circuit d'inhibition 10 dont une entrée 10A est reliée à un pôle positif VH de la source d'alimentation mentionnée ci-avant.

On notera que l'entrée 10A et la sortie 10B du circuit d'inhibition 10, ainsi que l'entrée 6A et la sortie 6B du capteur local 6 ont été représentées sur la figure 1 par un point pour faciliter la description de cette figure 1 et la compréhension des références utilisées sur cette figure 1. Il en sera fait de même par la suite pour la description des deuxième et troisième modes de réalisation.

Le capteur local 6 a une sortie 6B reliée électriquement à une entrée 8A du circuit local 8. Ensuite, le circuit d'inhibition 10 a une sortie 10B reliée électriquement à la sortie 6B du capteur local 6. Ce circuit d'inhibition 10 comporte également une borne de commande 10C destinée à être reliée à un circuit de commande (non représenté), agencé pour fournir à cette borne de commande 10C un signal de commande. Finalement, le circuit local 8 possède une sortie 8B reliée électriquement au circuit global 4.

On remarquera que, dans le présent mode de réalisation, la sortie 8B du circuit local 8 de toutes les cellules élémentaires du dispositif décrit ici sont reliées en parallèle au circuit global 4. Ce circuit global 4 est agencé de manière à fournir à une sortie 4A un signal global SG.

Le capteur local 6 de chacune des cellules élémentaires fournit à sa sortie 6B un signal de mesure SM. Quant au circuit d'inhibition, il fournit à sa sortie 10B un signal d'inhibition SI. Le circuit local 8 reçoit un signal local SL à son entrée 8A et fournit à sa sortie 8B un signal élémentaire SE. Ce signal élémentaire SE constitue le signal fourni par la cellule élémentaire au circuit global 4.

Dans le mode de réalisation décrit ici, le capteur local 6 est constitué par une photodiode 12. Le signal de mesure SM fourni par le capteur local 6 correspond au courant électrique circulant dans la photodiode 12, la valeur de ce courant électrique dépendant du niveau d'activation de la photodiode 12, c'est-à-dire de l'intensité lumineuse reçue par cette photodiode 12. On notera ici que l'invention ne se limite pas au cas où le capteur local est constitué par une photodiode. En fait, l'invention est sans autre applicable à tout capteur fournissant un signal de mesure formé par un courant électrique.

Le circuit d'inhibition 10 est formé, dans le présent mode de réalisation, par un seul transistor MOSFET 14. Ainsi, l'entrée 10A du circuit d'inhibition 10 correspond à la source du transistor 14, alors que la sortie 10B correspond au drain et la borne de commande 10C à la grille de ce transistor 14.

A titre d'exemple, le circuit local 8 est agencé de manière à former un convertisseur courant-tension et le circuit global 4 de manière à former un convertisseur tension-courant. Dans ce cas, le signal élémentaire SE est constitué par la tension à la sortie 8B du circuit local 8 et le signal global SG est constitué par le courant électrique fourni par le circuit global 4 à sa sortie 4A. Un tel agencement est approprié à la détermination du maximum d'intensité lumineuse reçue par le dispositif de l'invention. On notera ici que la présente invention ne se limite pas à la seule application mentionnée ci-avant.

On remarquera encore que le transistor 14 peut être constitué, dans une variante de ce mode de réalisation, par un transistor bipolaire. Dans ce cas, l'entrée 10A du circuit d'inhibition 10 est formé par l'émetteur de ce transistor bipolaire, alors que la sortie 10B forme le collecteur et la borne de commande 10C forme la base de ce transistor bipolaire.

Le circuit de commande, destiné à être relié à la borne de commande 10C du circuit d'inhibition 10, est agencé de manière à fournir à cette borne de commande 10C un signal de tension susceptible de prendre une première valeur pour laquelle le transistor 14 présente une faible impédance et une deuxième valeur pour laquelle le transistor présente une haute impédance. En particulier, le transistor 14 et la photodiode 12 sont agencés de manière que, lorsque le signal a ladite première valeur, le transistor 14 est susceptible de conduire la totalité du courant électrique fourni par la photodiode 12 et formant le signal de mesure SM. Par contre, lorsque le signal de commande a ladite deuxième valeur, le transistor 14 ne fournit sensiblement aucun courant de telle sorte que le signal d'inhibition SI a une valeur nulle. Dans ce dernier cas, la valeur du signal local SL entrant dans le circuit local 8 a une valeur sensiblement égale à la valeur du signal de mesure SM fourni par le capteur local 6.

En se référant ci-après à la figure 2, on décrira plus particulièrement le fonctionnement électrique du dispositif représenté à la figure 1.

Sur cette figure 2 ont été représentées diverses courbes caractéristiques de courant en fonction de la tension au noeud électrique X (voir figure 1) auquel sont reliées la sortie 6B du capteur local 6, la sortie 10B du circuit d'inhibition 10 et l'entrée 8A du circuit local 8.

La courbe 18 représente schématiquement la valeur du courant électrique formant le signal de mesure SM en fonction de la tension du noeud X. On notera ici que lorsqu'il est parlé dans le présent document de la tension d'un noeud, d'une borne ou d'un point, il est compris la valeur du potentiel de ce point relativement à une référence donnée.

La courbe 20 représente schématiquement la valeur du courant électrique formant le signal local SL en fonction de la valeur de la tension du noeud X. La courbe 22 représente schématiquement la valeur du courant électrique formant le signal d'inhibition SI en fonction de la valeur de la tension du noeud X dans le cas où la borne de commande 10C du circuit d'inhibition 10 a une tension dont la valeur est égale à la première valeur de tension susceptible d'être prise par le signal de commande agissant sur cette borne de commande 10C, comme cela a été décrit précédemment.

La courbe 18 correspond à un niveau donné d'activation de la photodiode 12. Pour divers niveaux d'activation de cette photodiode 12, on obtient diverses caractéristiques tension-courant sensiblement parallèles les unes aux autres, mais décalées l'une par rapport à l'autre. On notera ici que le circuit local 8 est agencé de telle manière que la valeur du signal élémentaire SE est une fonction univoque de la valeur du signal local SL sur tout le domaine de travail de la cellule élémentaire. Exprimé en terme de valeur de tension du noeud X, le domaine de travail de la cellule élémentaire mentionné ci-avant forme la plage de valeur de tension P2, représenté à la figure 2, ou à un sous-ensemble de cette plage P2.

La plage P2 est formée par l'ensemble des valeurs de tension du noeud X pour lesquelles le signal local SL prend une valeur sensiblement différente de zéro. La plage de valeur de tension P1, représentée sur cette figure 2, correspond à la plage de valeurs de tension du noeud X pour lesquelles la valeur du signal local SL est sensiblement égale à zéro. Sur toute cette plage P1, le signal élémentaire SE est sans influence mesurable sur le signal global SG fourni par le circuit global 4.

Par la suite, on dira que le circuit d'inhibition 10 est dans un mode passif lorsque le signal d'inhibition SI a une valeur sensiblement égale à zéro, ce qui est le cas sur toute la plage de valeurs de tension du noeud X correspondant au domaine de travail de la cellule élémentaire. En d'autres termes, le circuit d'inhibition 10 est dans son mode passif lorsqu'il présente une haute impédance en réponse au signal de commande agissant sur la borne de commande 10C du transistor 14. Par contre, lorsque le transistor 14 présente une faible impédance en réponse audit signal de commande agissant sur la borne de commande 10C du transistor 14, on dira que le circuit d'inhibition est dans un mode actif.

Lorsque le circuit d'inhibition est dans son mode passif, la valeur du signal de mesure SM est sensiblement égale à la valeur du signal local SL. Sur le graphe de la figure 2, la valeur de la tension du noeud X, correspondant à la valeur de tension de la sortie 6B du capteur local 6, et par conséquent de la photodiode 12 constituant ce capteur local 6, est repérée par le point VA et la valeur du courant circulant entre l'entrée 8A du circuit local 8 et la sortie 6B du capteur local 6 est repérée par le point IA. On notera que la valeur de tension VA est comprise dans la plage de valeurs de tension P2 et également dans la plage de valeurs de tension du noeud X correspondant au domaine de travail de la cellule élémentaire. Ainsi, lorsque le circuit d'inhibition est dans son mode passif, la cellule élémentaire correspondante est dans un mode actif, c'est-à-dire que le signal élémentaire SE fourni par cette cellule élémentaire au circuit global 4 est susceptible d'avoir une influence sur la valeur du signal global SG fourni par ce circuit global 4 à sa sortie 4A.

Par contre, lorsque le circuit d'inhibition 10 est dans son mode actif, la tension au noeud X passe à une valeur VP comprise dans la plage de valeurs de tension P1. Pour cette valeur de tension VP, le signal local SL a une valeur sensiblement nulle et la valeur du signal de mesure SM est sensiblement égale à la valeur du signal d'inhibition SI repérée par le point IP à la figure 2. Ainsi, lorsque le circuit d'inhibition 10 est dans son mode actif, la tension du noeud X est en dehors de la plage de valeur de tension P2 et la valeur du signal élémentaire SE se trouve en dehors du domaine de travail de la cellule élémentaire comprenant ce circuit d'inhibition 10.

De manière générale, la cellule élémentaire est agencée de manière que la valeur du signal élémentaire SE soit sans influence sur la valeur du signal global SG lorsque le circuit d'inhibition 10 de cette cellule élémentaire est dans son mode actif. L'ensemble des valeurs prises, lorsque le circuit d'inhibition 10 est dans un mode passif, par le signal élémentaire SE, pour l'ensemble des valeurs que le signal de mesure SM est susceptible de prendre lorsque le capteur local 6 est activé, définit une plage de valeur active pour le signal élémentaire. La plage de valeur active susmentionnée définit le domaine de travail de cette cellule élémentaire.

L'agencement du dispositif selon l'invention, représenté à l'aide des figures 1 et 2, permet d'effectuer un test de fonctionnement de chacune des cellules élémentaires CE1, CE2, CE3, CE4 et suivantes de ce dispositif. Pour ce faire, le circuit de commande (non représenté) est agencé de manière à fournir un signal de commande aux bornes de commande 10C des cellules élémentaires respectives permettant de mettre les circuits d'inhibition de toutes les cellules élémentaires dans un mode actif à l'exception d'une seule cellule élémentaire, et cela de manière sélective. De ce fait, le signal global SG fourni par le circuit global 4 sera représentatif du seul signal élémentaire SE de la cellule élémentaire ayant son circuit d'inhibition dans un mode passif. Il est ainsi possible de tester individuellement chaque cellule élémentaire, en particulier le fonctionnement du capteur local 6 associé au circuit local 8 de cette cellule élémentaire, et de tester conjointement le fonctionnement du circuit global.

Afin de permettre un test pour tout niveau d'activation des capteurs locaux, on agencera chaque cellule élémentaire de manière que le signal élémentaire fourni par le circuit local de cette cellule élémentaire ait une valeur hors de la plage de valeurs actives définie ci-avant lorsque les moyens d'inhibition sont dans un mode actif.

On remarquera cependant que l'activation des capteurs locaux durant un test peut être prescrite, et par conséquent les valeurs des signaux élémentaires fournis par les cellules élémentaires ayant leur circuit d'inhibition dans un mode actif sont sensiblement identiques et égales à une valeur déterminée. Afin que les cellules élémentaires mises dans leur mode passif soient sans affluence sur le signal global SG fourni par le circuit global 4, il suffira dans ce cas que ce circuit global 4 soit agencé de manière que le signal global SG ne dépende pas de tout signal élémentaire ayant la valeur déterminée susmentionnée.

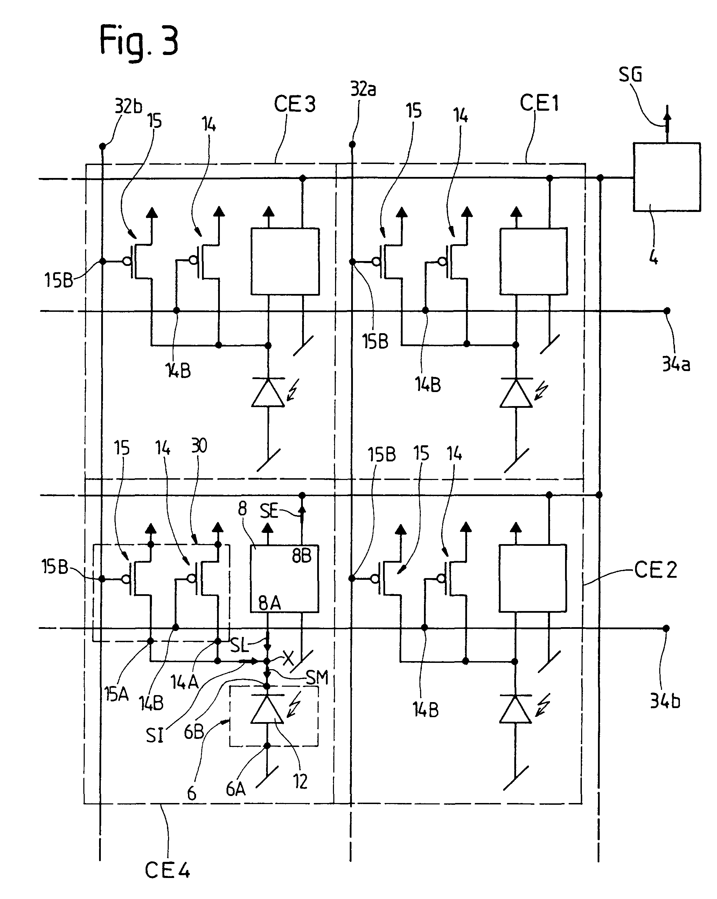

En se référant ci-après à la figure 3, on décrira un deuxième mode de réalisation d'un dispositif selon l'invention.

Ce dispositif est formé de N cellules élémentaires CE1, CE2, CE3, ...., CEN, N étant un nombre entier supérieur à 3. Les N cellules élémentaires du dispositif sont disposées de manière à former une matrice de cellules élémentaires, c'est-à-dire qu'elles sont disposées de manière à former Y lignes et Z colonnes.

Toutes les cellules élémentaires sont identiques. Ainsi, à nouveau, pour ne pas charger inutilement le dessin de la figure 3, seuls les éléments de la cellule CE4 sont tous désignés par une référence. Ensuite, les références déjà décrites lors de la description du premier mode de réalisation ne seront pas à nouveau décrites en détail ici.

Ce deuxième mode de réalisation de l'invention se distingue du premier mode de réalisation uniquement par l'agencement du circuit d'inhibition 30 et par la manière dont les circuits d'inhibition des N cellules élémentaires sont reliées à un circuit de commande non représenté, seules les liaisons électriques entre les circuits d'inhibition 30 et des bornes de test 32a, 32b, 34a et 34b étant représentées sur la figure 3. Les bornes de test 32a, 32b, 34a et 34b sont destinées à être reliées au circuit de commande susmentionné. On notera que sur la figure 3, seules quatre cellules élémentaires CE1, CE2, CE3 et CE4 ont été représentées. Cependant, le dispositif de l'invention selon ce deuxième mode de réalisation peut comprendre un nombre bien plus important de cellules élémentaires.

Le circuit d'inhibition 30 comprend un premier transistor 14 et un deuxième transistor 15. La borne de sortie 14A du transistor 14 et la borne de sortie 15A du transistor 15 sont toutes deux reliées au noeud X auquel le circuit d'inhibition 30 fournit un signal d'inhibition SI. Bien que séparés sur la figure 3, le noeud X et la sortie 6B du capteur local 6 sont électriquement confondus.

Les caractéristiques électriques des deux transistors 14 et 15 sont sensiblement identiques et semblables à celles décrites ci-avant à l'aide de la figure 2. Ainsi, chacun des deux transistors 14 et 15 est susceptible, lorsqu'il est dans un état de faible impédance, de fournir un signal d'inhibition SI capable d'inhiber entièrement le signal de mesure SM du capteur local 6. En d'autres termes, les deux transistors 14 et 15 sont agencés de manière que chacun d'eux est capable de fournir un signal d'inhibition SI dont la valeur est égale à celle du signal de mesure SM. Chacun des deux transistors 14 et 15 peut ainsi, sans la contribution de l'autre, assurer à lui tout seul la fonction d'inhibition du circuit d'inhibition 30. D'un autre côté, lorsque les deux transistors 14 et 15 présentent une faible impédance, le signal d'inhibition SI est formé par la contribution des deux transistors 14 et 15.

La borne de commande 14B du transistor 14 de l'une quelconque des cellules élémentaires est reliée électriquement en parallèle à une borne de test 34a, 34b ou suivantes avec les bornes de commande 14B des premiers transistors 14 des cellules élémentaires situées sur la même ligne de la matrice de cellules élémentaires du dispositif décrit présentement. La borne de commande 15B du second transistor 15 de l'une quelconque des cellules élémentaires est reliée électriquement en parallèle à une borne de test 32a, 32b ou suivantes avec les cellules élémentaires situées sur la même colonne de la matrice de cellules élémentaires du dispositif décrit présentement.

Le signal de commande fourni au circuit d'inhibition 30 d'une cellule élémentaire par le circuit de commande (non représenté) est formé, dans ce deuxième mode de réalisation, de deux signaux binaires agissant respectivement sur la borne de commande 14B du premier transistor 14 et sur la bande de commande 15B du second transistor 15. Pour ce qui concerne par exemple la cellule élémentaire CE4, le premier signal binaire fourni au transistor 14 provient de la borne de test 34b. Le second signal binaire fourni au second transistor 15 de cette cellule élémentaire CE4 provient de la borne de test 32b.

Dans la réalisation particulière du dispositif représenté à la figure 3, les premier et second transistors 14 et 15 sont des transistors MOSFET du type-p. Ainsi, lorsque les transistors 14 et 15 ont leurs bornes de commande respectives 14B et 15B a une tension haute, ils ont une haute impédance et ne délivre sensiblement aucun courant électrique au noeud X. Par contre, lorsque ces bornes 14B et 15B ont une tension basse, ces transistors 14 et 15 ont une faible impédance et sont susceptibles de délivrer un courant électrique dont la valeur est égale à celle du signal de mesure SM provenant du capteur local 6.

Les deux signaux binaires, formant le signal de commande fourni à l'une quelconque des cellules élémentaires, sont formés respectivement de deux signaux de tension pouvant prendre une valeur haute et une valeur basse. Ainsi, le signal de commande fourni à l'une quelconque des cellules élémentaires est susceptible de prendre quatre valeurs différentes. La première valeur correspond à une faible impédance du premier transistor 14 et une haute impédance du second transistor 15. La deuxième valeur correspond à une haute impédance pour les deux transistors 14 et 15. La troisième valeur correspond à une haute impédance du premier transistor 14 et une faible impédance du second transistor 15. Finalement, la quatrième valeur correspond à une faible impédance pour les deux transistors 14 et 15.

On remarquera que le circuit d'inhibition 30 est dans un mode passif seulement pour la deuxième valeur susmentionnée. Pour les trois autres valeurs, le circuit d'inhibition 30 est dans un mode actif. Grâce à l'agencement du circuit d'inhibition 30, à l'adressage en lignes et en colonnes du signal de commande et à la structure de ce signal de commande décrite ci-avant, il est possible d'inhiber toutes les cellules élémentaires sauf une quelconque de ces cellules élémentaires. En d'autres termes, le dispositif selon le deuxième mode de réalisation de l'invention permet de mettre dans un mode passif l'ensemble des cellules élémentaires de ce dispositif, à l'exclusion d'une quelconque de ces cellules élémentaires qui est mise dans un mode actif.

Comme dans le premier mode de réalisation, il est ainsi possible de tester individuellement chacune des cellules élémentaires, en particulier le capteur local 6 et le circuit local 8 de chacune des cellules élémentaires du dispositif. Ce qui vient d'être mentionné provient du fait qu'il est possible de commander le dispositif décrit ici de manière que le signal de commande fourni à l'une quelconque des cellules élémentaires ait la deuxième valeur susmentionnée, pour laquelle les deux transistors 14 et 15 ont une haute impédance, et que les signaux de commande fournis à toutes les autres cellules élémentaires aient une valeur différente de cette deuxième valeur. A l'aide d'une simple logique, un tel adressage est possible à l'aide des seules bornes de test 32a, 32b et suivantes et 34a, 34b et suivantes.

Ainsi, par rapport au premier mode de réalisation décrit ci-avant, le nombre de bornes de test entre les cellules élémentaires et le circuit de commande est sensiblement diminué. Par exemple, pour un dispositif comprenant Y lignes de cellules élémentaires et également Y colonnes de cellules élémentaires, le nombre de bornes de test reliées au circuit de commande est égal à deux fois Y dans ce second mode de réalisation, alors qu'il est égal à Y² dans le premier mode de réalisation selon l'invention.

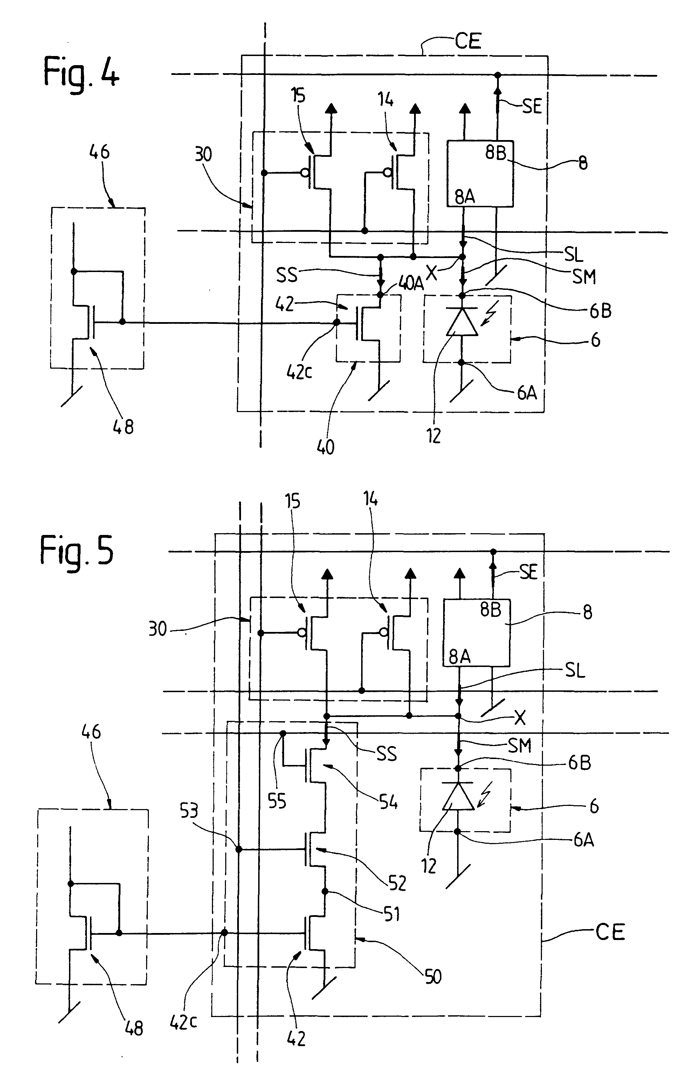

En se référant ci-après à la figure 4, on décrira brièvement un troisième mode de réalisation d'un dispositif selon l'invention.

Sur cette figure 4 a été représenté une seule cellule élémentaire CE d'un dispositif comprenant une pluralité de cellules élémentaires identiques. Le dispositif selon ce troisième mode de réalisation se distingue du dispositif du deuxième mode de réalisation par le fait que chaque cellule comporte en plus un circuit de stimulation 40.

Le circuit de stimulation 40 est constitué par un transistor 42, en particulier un transistor MOSFET du type-n. Le circuit de stimulation 40 a sa sortie 40A reliée électriquement au noeud X. Dans une variante, la sortie 40A du circuit de stimulation 40 peut être reliée directement à la sortie 6B du capteur local 6. Electriquement, ces deux cas sont équivalents. Le circuit de stimulation 40 sert à fournir un signal de stimulation SS formé par un signal de courant.

Le transistor 42 a sa grille 42C reliée à un circuit de commande en tension 46 permettant de déterminer la valeur du courant électrique du signal de stimulation SS. Dans le cas particulier de la figure 4, le transistor 42 et le transistor 48 du circuit de commande 46 forment un miroir de courant. Le circuit de stimulation 40 est relié électriquement en parallèle avec le capteur local 6 au circuit local 8. Ainsi, le signal de stimulation SS vient s'ajouter au signal de mesure SM. Ils forment le signal local SL fourni à l'entrée 8A du circuit local 8 lorsque le circuit d'inhibition 30 est dans son mode passif.

Le circuit de stimulation 40 permet ainsi de varier artificiellement la valeur du signal local SL. En particulier, lorsque le capteur local 6 n'est pas activé, c'est-à-dire que le signal de mesure SM a une valeur nulle ou une valeur de référence quelconque, il est possible de substituer le circuit de stimulation 40 au capteur local 6 pour tester le circuit local 8 et le circuit global (non représenté sur cette figure 4). Le circuit de stimulation 40 pouvant donc être substitué au capteur local 6, il est possible d'utiliser le circuit d'inhibition 30 de manière identique au deuxième mode de réalisation décrit ci-avant pour tester individuellement le circuit local 8 de chacune des cellules élémentaires du dispositif selon ce troisième mode de réalisation.

Ainsi, dans le cas particulier où le capteur local 6 est constitué par une photodiode 12, l'agencement des cellules élémentaires du dispositif décrit à la figure 4 permet de tester individuellement chacun des circuits locaux 8 et le fonctionnement du circuit d'inhibition 30 qui lui est associé sans activer le photodiode 12, c'est-à-dire en travaillant dans le noir ou à faible luminosité.

Le circuit de stimulation 40 associé au circuit d'inhibition 30 dans chacune des cellules élémentaires du dispositif selon le troisième mode de réalisation de l'invention permet donc de faire différents tests permettant de s'assurer du bon fonctionnement de chacune des cellules élémentaires du dispositif, et par conséquent du dispositif lui-même.

En se référant à la figure 5, on décrira ci-après une variante du troisième mode de réalisation du dispositif selon l'invention.

A nouveau, une seule cellule élémentaire CE du dispositif a été représentée sur cette figure 5. Cette variante de réalisation se distingue de la variante décrite à l'aide de la figure 4 seulement par l'agencement du circuit de stimulation 50. Ce circuit de stimulation 50 comporte à nouveau un transistor MOSFET 42 dont la borne de commande 42c, formée par la grille de ce transistor, est reliée à un circuit de commande 46, en particulier à un transistor MOSFET 48 servant à commander la valeur de la tension de la grille du transistor 42. De plus, le circuit de stimulation 50 comprend deux autres transistors MOSFET 52 et 54 du type-n. Ces deux transistors 52 et 54 sont reliés électriquement en série entre la sortie 51 du transistor 42 et le noeud X ou la sortie 6B du capteur local 6.

Les deux transistors 52 et 54 servent d'interrupteur de courant permettant de fournir au noeud X un signal de stimulation SS dont la valeur est nulle pour un certain nombre de cellules élémentaires et non-nulle pour d'autres cellules élémentaires. En particulier, les deux transistors 52 et 54 ont leurs bornes de commande respectives 53 et 55 reliées à un circuit de commande (non représenté) permettant d'ouvrir ou de fermer indépendamment les deux interrupteurs formés respectivement par les transistors 52 et 54. Il a été prévu deux transistors 52 et 54 pour permettre un adressage en lignes et en colonnes des bornes de commande respectives 53 et 55 tout en permettant que le circuit de stimulation 50 puisse être actif pour une quelconque des cellules élémentaires du dispositif et passif pour toutes les autres cellules élémentaires. Ceci est réalisé par un signal de commande semblable au signal de commande du circuit d'inhibition 30 du deuxième mode de réalisation décrit ci-avant en prenant en compte dans la logique d'adressage que les transistors 52 et 54 sont du type-n.

On remarquera qu'il est possible de relier électriquement la grille du transistor 42 de chacune des cellules élémentaires du dispositif au même transistor 48 du circuit de commande 46. On notera ici que le circuit de commande 46 peut être intégré avec les cellules élémentaires au dispositif selon l'invention.

La variante de réalisation décrite à l'aide de la figure 5 permet de faire un grand nombre de test du dispositif selon l'invention par une commande judicieuse du circuit d'inhibition 30 et du circuit de stimulation 50 de chacune des cellules élémentaires CE. De ce fait, il est possible à l'aide d'un nombre de bornes de test limités d'effectuer un grand nombre de test et en particulier de tester individuellement chaque circuit des cellules élémentaires du dispositif selon l'invention.

## Revendications

1. Dispositif comprenant N cellules élémentaires (CE1, CE2, CE3, CE4; CE) comprenant chacune un ensemble local formé d'un capteur local (6), susceptible de fournir un signal de mesure (SM) à une sortie (6B) de ce capteur local, et d'un circuit local (8) agencé de manière à fournir un signal élémentaire (SE) en réponse audit signal de mesure, ledit dispositif étant **caractérisé en ce qu'**il comprend en outre un circuit global (4) agencé de manière à fournir un signal global (SG) qui est fonction des N signaux élémentaires (SE) fournis simultanément par les N circuits locaux (6), chacune des N cellules élémentaires comprenant en outre des moyens d'inhibition (10;30), répondant à un premier signal de commande susceptible de prendre sélectivement une première valeur et une deuxième valeur, pour agir sur ledit ensemble local de ladite chacune des N cellules élémentaires de manière que ledit signal élémentaire fourni par ledit circuit local de ladite chacune des N cellules élémentaires soit sensiblement sans influence sur ledit signal global lorsque ledit premier signal de commande a ladite première valeur, lesdits moyens d'inhibition n'ayant sensiblement aucune influence sur ledit ensemble local de ladite chacune des N cellules élémentaires lorsque ledit premier signal de commande a ladite deuxième valeur.

2. Dispositif selon la revendication 1, **caractérisé en ce que** ledit circuit local (8) a une entrée (8A) reliée électriquement à ladite sortie (6B) dudit capteur local (6) et **en ce que** lesdits moyens d'inhibition (10;30) sont également reliés électriquement à ladite sortie dudit capteur local, ces moyens d'inhibition étant agencés pour fournir un signal d'inhibition (SI) à ladite sortie dudit capteur local.

3. Dispositif selon la revendication 2, **caractérisé en ce que** lesdits moyens d'inhibition (10;30) et ledit ensemble local (6,8) sont agencés de manière que la tension à la sortie (6B) dudit capteur local (6) a une valeur comprise dans une première plage (P1) de valeurs de tension lorsque ledit premier signal de commande a ladite première valeur et dans une deuxième plage (P2) de valeur de tension lorsque ledit premier signal de commande a ladite deuxième valeur, ledit circuit local (8) recevant à ladite entrée un signal local (SL) ayant une valeur sensiblement constante lorsque la tension à ladite sortie (6B) dudit capteur local (6) a une valeur comprise dans ladite première plage de valeurs de tension.

4. Dispositif selon la revendication 3, **caractérisé en ce que** ledit circuit local (8) est agencé de manière que ledit signal local (SL) a sensiblement une valeur nulle lorsque la tension à ladite sortie (6B) dudit capteur local (6) a une valeur comprise dans ladite première plage (P1) de valeurs de tension.

5. Dispositif selon la revendication 3 ou 4, **caractérisé en ce que** ledit signal de mesure (SM) fourni par chaque capteur local (6) est un courant électrique et **en ce que** lesdits moyens d'inhibition (10;30) de chaque cellule élémentaire (CE1, CE2, CE3, CE4; CE) comprennent un premier transistor (14) ayant sa sortie (10B;14A) reliée à ladite sortie (6B) dudit capteur local (6) et sa borne de commande (10C;14B) susceptible d'être reliée à un circuit de commande agencé pour lui fournir ledit premier signal de commande, ledit premier transistor (14) ayant une faible impédance lorsque ledit premier signal de commande a ladite première valeur et une haute impédance lorsque ce premier signal de commande a ladite deuxième valeur.

6. Dispositif selon la revendication 5, **caractérisé en ce que** lesdites N cellules élémentaires (CE1, CE2, CE3, CE4; CE) sont disposées de manière à former une matrice de cellules élémentaires, et **en ce que** lesdits moyens d'inhibition (30) comprennent en outre un deuxième transistor (15) ayant sa sortie (15A) reliée à ladite sortie dudit capteur local et sa borne de commande (15B) reliée audit circuit de commande, ledit premier signal de commande étant susceptible de prendre en outre une troisième valeur et une quatrième valeur, ledit deuxième transistor ayant une haute impédance lorsque ledit premier signal de commande a ladite première valeur ou ladite deuxième valeur et une faible impédance lorsque ce premier signal de commande a ladite troisième valeur ou ladite quatrième valeur, ledit premier transistor ayant une haute impédance lorsque ledit premier signal de commande a ladite troisième valeur et une faible impédance lorsque ce premier signal de commande a ladite quatrième valeur, la tension à ladite sortie (6B) dudit capteur local (6) ayant une valeur comprise dans ladite première plage (P1) de valeurs de tension lorsque ledit premier signal de commande a ladite troisième valeur ou ladite quatrième valeur.

7. Dispositif selon la revendication 6, **caractérisé en ce que** ledit premier transistor (14) d'une quelconque desdites N cellules élémentaires (CE1, CE2, CE3, CE4; CE) a sa borne de commande (14B) reliée en parallèle avec les bornes de commande (14B) des premiers transistors, appartenant aux cellules élémentaires situées sur la même ligne de ladite matrice, à une même première borne de test (34a,34b), et **en ce que** ledit deuxième transistor (15) d'une quelconque desdites N cellules élémentaires a sa borne de commande (15B) reliée en parallèle avec les bornes de commande (15B) des deuxièmes transistors, appartenant aux cellules élémentaires situées sur la même colonne de ladite matrice, à une deuxième borne de test (32a,32b), ledit premier signal de commande fourni auxdits moyens d'inhibition (30) de chacune desdites N cellules élémentaires étant formé de deux signaux binaires.

8. Dispositif selon l'une quelconque des revendications précédentes, **caractérisé en ce que** chacune desdites N cellules élémentaires (CE) comprend en outre des moyens de stimulation (40;50) reliés électriquement à ladite sortie (6B) dudit capteur local (6) et susceptibles de fournir à cette sortie un signal de stimulation (SS) lorsque lesdits moyens de stimulation de ladite chacune desdites N cellules élémentaires sont activés.

9. Dispositif selon la revendication 8, **caractérisé en ce que** lesdits moyens de stimulation (40;50) comprennent un troisième transistor (42) dont la borne de commande (42C) est susceptible d'être reliée à un circuit externe (46) à ladite chacune desdites N cellules élémentaires (CE), ce circuit externe servant à commander la valeur de la tension de ladite borne de commande dudit troisième transistor.

10. Dispositif selon la revendication 9, **caractérisé en ce que** lesdits moyens de stimulation (50) comprennent en outre des moyens d'interruption de courant (52,54) agencés entre la sortie (51) dudit troisième transistor (42) et ladite sortie (6B) dudit capteur local (6), ces moyens d'interruption étant susceptibles d'être reliés audit circuit de commande, ce dernier étant agencé pour fournir à ces moyens d'interruption de courant un deuxième signal de commande, lesdits moyens d'interruption et ledit circuit de commande étant agencés de manière à ce que lesdits moyens de stimulation (50) desdites N cellules élémentaires (CE) puissent être sélectivement activés en réponse audit deuxième signal de commande.

11. Dispositif selon l'une quelconque des revendications précédentes, **caractérisé en ce que** ledit capteur local (6) est une photodiode (12).

## Patentansprüche

1. Vorrichtung, die N Elementarzellen (CE1, CE2, CE3, CE4; CE) umfaßt, die jeweils eine lokale Einheit enthalten, die aus einem lokalen Sensor (6), der an einem Ausgang (6B) dieses lokalen Sensors ein Meßsignal (SM) liefern kann, und aus einer lokalen Schaltung (8), die so beschaffen ist, daß sie als Antwort auf das Meßsignal ein Elementarsignal (SE) liefern kann, gebildet ist, wobei die Vorrichtung **dadurch gekennzeichnet ist, daß** sie außerdem eine globale Schaltung (4) umfaßt, die so beschaffen ist, daß sie ein globales Signal (SG) liefert, das von den von den N lokalen Schaltungen (6) gleichzeitig gelieferten N Elementarsignalen (SE) abhängt, wobei jede der N Elementarzellen außerdem Sperrmittel (10; 30) umfaßt, die auf ein erstes Steuersignal, das wahlweise einen ersten Wert und einen zweiten Wert annehmen kann, antworten, um auf die lokale Einheit jeder der N Elementarzellen in der Weise einzuwirken, daß das von der lokalen Schaltung jeder der N Elementarzellen gelieferte Elementarsignal im wesentlichen nicht das globale Signal beeinflußt, wenn das erste Steuersignal den ersten Wert hat, während die Sperrmittel im wesentlichen keinerlei Einfluß auf die lokale Einheit jeder der N Elementarzellen haben, wenn das erste Steuersignal den zweiten Wert hat.

2. Vorrichtung nach Anspruch 1, **dadurch gekennzeichnet, daß** die lokale Schaltung (8) einen mit dem Ausgang (6B) des lokalen Sensors (6) elektrisch verbundenen Eingang (8A) besitzt und daß die Sperrmittel (10; 30) außerdem mit dem Ausgang des lokalen Sensors elektrisch verbunden sind, wobei diese Sperrmittel so beschaffen sind, daß sie an den Ausgang des lokalen Sensors ein Sperrsignal (SI) liefern.

3. Vorrichtung nach Anspruch 2, **dadurch gekennzeichnet, daß** die Sperrmittel (10; 30) und die lokale Einheit (6, 8) so beschaffen sind, daß die Spannung am Ausgang (6B) des lokalen Sensors (6) einen Wert hat, der in einem ersten Bereich (P1) von Spannungswerten liegt, wenn das erste Steuersignal den ersten Wert hat, und in einem zweiten Bereich (P2) von Spannungswerten liegt, wenn das erste Steuersignal den zweiten Wert hat, wobei die lokale Schaltung (8) an dem Eingang ein lokales Signal (SL) empfängt, das einen im wesentlichen konstanten Wert hat, wenn die Spannung am Ausgang (6B) des lokalen Sensors (6) einen Wert hat, der im ersten Bereich von Spannungswerten liegt.

4. Vorrichtung nach Anspruch 3, **dadurch gekennzeichnet, daß** die lokale Schaltung (8) so beschaffen ist, daß das lokale Signal (SL) im wesentlichen den Wert null hat, wenn die Spannung am Ausgang (6B) des lokalen Sensors (6) einen Wert hat, der im ersten Bereich (P1) von Spannungswerten liegt.

5. Vorrichtung nach Anspruch 3 oder 4, **dadurch gekennzeichnet, daß** das von jedem lokalen Sensor (6) gelieferte Meßsignal (SM) ein elektrischer Strom ist und daß die Sperrmittel (10; 30) jeder Elementarzelle (CE1, CE2, CE3, CE4; CE) einen ersten Transistor (14) umfassen, der mit seinem Ausgang (10B; 14A) mit dem Ausgang (6B) des lokalen Sensors (6) verbunden ist und dessen Steueranschluß (10C; 14B) mit einer Steuerschaltung verbunden werden kann, die so beschaffen ist, daß sie an ihn das erste Steuersignal liefern kann, wobei der erste Transistor (14) eine geringe Impedanz besitzt, wenn das erste Steuersignal den ersten Wert hat, und eine hohe Impedanz besitzt, wenn dieses erste Steuersignal den zweiten Wert hat.

6. Vorrichtung nach Anspruch 5, **dadurch gekennzeichnet, daß** die N Elementarzellen (CE1, CE2, CE3, CE4; CE) in der Weise angeordnet sind, daß sie eine Matrix aus Elementarzellen bilden, und daß die Sperrmittel (30) außerdem einen zweiten Transistor (15) umfassen, dessen Ausgang (15A) mit dem Ausgang des lokalen Sensors verbunden ist und dessen Steueranschluß (15B) mit der Steuerschaltung verbunden ist, wobei das erste Steuersignal außerdem einen dritten Wert und einen vierten Wert annehmen kann, wobei der zweite Transistor eine hohe Impedanz besitzt, wenn das erste Steuersignal den ersten Wert oder den zweiten Wert hat, und eine geringe Impedanz besitzt, wenn dieses erste Steuersignal den dritten Wert oder den vierten Wert hat, wobei der erste Transistor eine hohe Impedanz besitzt, wenn das erste Steuersignal den dritten Wert hat, und eine geringe Impedanz besitzt, wenn dieses erste Steuersignal den vierten Wert hat, wobei die Spannung am Ausgang (6B) des lokalen Sensors (6) einen Wert besitzt, der in dem ersten Bereich (P1) von Spannungswerten liegt, wenn das erste Steuersignal den dritten Wert oder den vierten Wert hat.

7. Vorrichtung nach Anspruch 6, **dadurch gekennzeichnet, daß** der erste Transistor (14) irgendeiner der N Elementarzellen (CE1, CE2, CE3, CE4; CE) mit seinem Steueranschluß (14B) parallel zu den Steueranschlüssen (14B) der ersten Transistoren, die zu den in derselben Zeile der Matrix befindlichen Elementarzellen gehören, mit einem ersten Prüfanschluß (34a, 34b) verbunden ist und daß der zweite Transistor (15) irgendeiner der N Elementarzellen mit seinem Steueranschluß (15B) parallel zu den Steueranschlüssen (15B) der zweiten Transistoren, die zu den in derselben Spalte in der Matrix befindlichen Elementarzellen gehören, mit einem zweiten Prüfanschluß (32A, 32B) verbunden ist, wobei das erste Steuersignal, das an die Sperrmittel (30) jeder der N Elementarzellen geliefert wird, aus zwei binären Signalen gebildet ist.

8. Vorrichtung nach einem der vorhergehenden Ansprüche, **dadurch gekennzeichnet, daß** jede der N Elementarzellen (CE) außerdem Stimulationsmittel (40; 50) umfaßt, die mit dem Ausgang (6B) des lokalen Sensors (6) elektrisch verbunden sind und an diesen Ausgang ein Stimulationssignal (SS) liefern können, wenn die Stimulationsmittel jeder der N Elementarzellen aktiviert sind.

9. Vorrichtung nach Anspruch 8, **dadurch gekennzeichnet, daß** die Stimulationsmittel (40; 50) einen dritten Transistor (42) umfassen, dessen Steueranschluß (42C) mit einer Schaltung (46) verbunden werden kann, die sich außerhalb jeder der N Elementarzellen (CE) befindet, wobei diese externe Schaltung dazu dient, den Wert der Spannung des Steueranschlusses des dritten Transistors zu steuern.

10. Vorrichtung nach Anspruch 9, **dadurch gekennzeichnet, daß** die Stimulationsmittel (50) außerdem Stromunterbrechungsmittel (52, 54) umfassen, die zwischen dem Ausgang (51) des dritten Transistors (42) und dem Ausgang (6B) des lokalen Sensors (6) angeordnet sind, wobei diese Unterbrechungsmittel mit der Steuerschaltung verbunden werden können, wobei diese letztere so beschaffen ist, daß sie an diese Stromunterbrechungsmittel ein zweites Steuersignal liefert, wobei die Unterbrechungsmittel und die Steuerschaltung so beschaffen sind, daß die Stimulationsmittel (50) der N Elementarzellen (CE) als Antwort auf das zweite Steuersignal wahlweise aktiviert werden können.

11. Vorrichtung nach einem der vorhergehenden Ansprüche, **dadurch gekennzeichnet, daß** der lokale Sensor (6) eine Photodiode (12) ist.

## Claims

1. Arrangement comprising N elementary cells (CE1, CE2, CE3, CE4; CE) each comprising a local assembly formed from a local sensor (6), capable of furnishing a measurement signal (SM) at an output (6B) of such local sensor and from a local circuit (8) arranged in a manner to furnish an elementary signal (SE) in response to said measurement signal, said arrangement being **characterized in that** it moreover comprises a global circuit (4) arranged in a manner to form an aggregate signal (SG) which is function of the N elementary signals (SE) simultaneously furnished by the N local circuits (8), each of the N elementary cells furthermore comprising inhibition means (10; 30) responding to a first control signal capable of assuming selectively a first value and a second value, so as to act on said local assembly of said each of the N elementary cells in a manner that each elementary signal furnished by said local circuit of said each of the N elementary cells is substantially without influence on said aggregate signal when said first control signal has said first value, said inhibition means having substantially no influence on said local assembly of said each of the N elementary cells when said first control signal has said second value.

2. Arrangement according to claim 1, **characterized in that** said local circuit (8) has an input (8A) electrically coupled to said output (6B) of said local sensor (6) and **in that** said inhibition means (10; 30) are likewise electrically coupled to said output of said local sensor, such inhibition means being arranged so as to furnish an inhibition signal (SI) to said output of said local sensor.

3. Arrangement according to claim 2, **characterized in that** said inhibition means (10; 30) and said local assembly (6, 8) are arranged in a manner such that the tension at the output (6B) of said local sensor (6) has a value comprised within a first range (P1) of voltage values when said first control signal has said first value and within a second range (P2) of voltage values when said first control signal has said second value, said local circuit (8) receiving at said input a local signal (SL) having a substantially constant value when the tension at said output (6B) of said local sensor (6) has a value comprised within said first range of voltage values.

4. Arrangement according to claim 3, **characterized in that** said local circuit (8) is arranged in a manner such that said local signal (SL) has a substantially null value when the tension at said output (6B) of said local sensor (6) has a value comprised within said first range (P1) of voltage values.

5. Arrangement according to claim 3 or 4, **characterized in that** said measurement signal (SM) furnished by each local sensor (6) is an electric current and **in that** said inhibition means (10; 30) of each elementary cell (CE1, CE2, CE3, CE4; CE) comprise a first transistor (14) having its output (10B; 14A) coupled to said output (6B) of said local sensor (6) and its control terminal (10C; 14B) capable of being coupled to a control circuit arranged to furnish said first control signal to it, said first transistor (14) having low impedance when said first control signal has said first value and high impedance when said first control signal has said second value.

6. Arrangement according to claim 5, **characterized in that** said N elementary cells (CE1, CE2, CE3, CE4; CE) are arranged in a manner so as to form a matrix of elementary cells, and **in that** said inhibition means (30) further comprise a second transistor (15) having its output (15A) coupled to said output of said local sensor and its control terminal (15B) coupled to said control circuit, said first control signal being capable of additionally assuming a third value and a fourth value, said second transistor having high impedance when said first control signal has said first value or said second value and low impedance when said first control signal has said third value or said fourth value, said first transistor having high impedance when said first control signal has said third value and low impedance when said first control signal has said fourth value, the voltage at said output (6B) of said local sensor (6) having a value comprised within said first range (P1) of voltage values when said first control signal has said third value or said fourth value.

7. Arrangement according to claim 6, **characterized in that** said first transistor (14) of any one whatsoever of said N elementary cells (CE1, CE2. CE3, CE4; CE) has its control terminal (14B) coupled in parallel with the control terminals (14B) of the first transistors, belonging to the elementary cells located in the same row of said matrix, to a common first test terminal (34a, 34b), and **in that** said second transistor (15) of any one whatsoever of said N elementary cells has its control terminal (15B) coupled in parallel with the control terminals (15B) of the second transistors, belonging to the elementary cells located in the same column of said matrix, to a second test terminal (32a, 32b), said first control signal furnished to said inhibition means (30) of each of said N elementary cells being formed from two binary signals.

8. Arrangement according to any one of the preceding claims, **characterized in that** each of said N elementary cells (CE) further comprises stimulating means (40; 50) electrically coupled to said output (6B) of said local sensor (6) and capable of furnishing a stimulation signal (SS) to such output when said stimulating means of said each of said N elementary cells are activated.

9. Arrangement according to claim 8, **characterized in that** said stimulating means (40; 50) comprise a third transistor (42), the control terminal (42C) of which is capable of being coupled to a circuit (46) external to said each of said N elementary cells (CE), such external circuit serving to control the voltage value at said control terminal of said third transistor.

10. Arrangement according to claim 9, **characterized in that** said stimulating means (50) further comprise current interruption means (52, 54) arranged between the output (51) of said third transistor (42) and said output (6B) of said local sensor (6), such interruption means being capable of being coupled to said control circuit, such latter being arranged to furnish a second control signal to such current interruption means, said interruption means and said control circuit being arranged in a manner such that said stimulating means (50) of said N elementary cells (CE) can be selectively activated in response to said second control signal.

11. Arrangement according to any one of the preceding claims, **characterized in that** said local sensor (6) is a photodiode (12).
